# EUROPEAN PATENT SPECIFICATION

(11) **EP 4 329 114 B1**
(45) Date of publication and mention of the grant of the patent: **04.11.2026**
(21) Application number: 22794734.8
(22) Date of filing: 21.04.2022
(51) Int. Cl.: G06N 10/20, G06N 10/40, H01S 5/10, H01S 5/06, H01S 5/062

(54) **COHERENT ISING MACHINE BASED ON ON-CHIP WHISPERING GALLERY MODE OPTICAL MICROCAVITY**
KOHÄRENTE ISING-MASCHINE AUF BASIS EINES OPTISCHEN ON-CHIP-MIKROHOHLRAUMS IM FLÜSTERGALERIEMODUS
MACHINE D'ISING COHÉRENTE BASÉE SUR UNE MICROCAVITÉ OPTIQUE SUR PUCE EN MODE DE GALERIE

(30) Priority: 25.04.2021 CN 202110447214
(43) Date of publication of application: 28.02.2024
(73) Proprietor: Beijing QBoson Quantum Technology Co., Ltd., Beijing 100016 (CN)
(72) Inventor: WEN, Kai, Beijing 100016 (CN); MA, Yin, Beijing 100016 (CN)
(74) Representative: Bayramoglu et al.
(86) International application number: PCT/CN2022/088132
(87) International publication number: WO 2022/228263

(56) References cited:
- CN-A- 105 896 235
- CN-A- 107 508 140
- CN-A- 113 178 775
- CN-B- 105 896 235
- JP-A- 2015 163 922
- JP-A- 2018 147 228
- MCMAHON PETER L. ET AL: "A fully programmable 100-spin coherent Ising machine with all-to-all connections", SCIENCE, vol. 354, no. 6312, 4 November 2016 (2016-11-04), US, pages 614 - 617, XP093227390, ISSN: 0036-8075, DOI: 10.1126/science.aaf6702
- MCMAHON PETER L. ET AL: "A fully programmable 100-spin coherent Ising machine with all-to-all connections", SCIENCE, vol. 354, no. 6312, 4 November 2016 (2016-11-04), US, pages 614 - 617, XP093226996, ISSN: 0036-8075, DOI: 10.1126/science.aah5178
- HORI MASAKI, AGHAI-KHOZANI HOSSEIN, SÓTÉR ANNA, BARNA DANIEL, DAX ANDREAS, HAYANO RYUGO, KOBAYASHI TAKUMI, MURAKAMI YOHEI, TODOROK: "Buffer-gas cooling of antiprotonic helium to 1.5 to 1.7 K, and antiproton-to–electron mass ratio", SCIENCE, vol. 354, no. 6312, 4 November 2016 (2016-11-04), US , pages 610 - 614, XP055982637, ISSN: 0036-8075, DOI: 10.1126/science.aaf6702

## Description

This application claims priority to an early Chinese Patent entitled "A COHERENT ISING MACHINE BASED ON ON-CHIP WHISPERING GALLERY MODE OPTICAL MICROCAVITY" (Application No. 202110447214.3) filed with the China National Intellectual Property Administration on April 25, 2021.

### TECHNICAL FIELD

The invention relates to the field of integration design technologies, in particular to a coherent Ising machine based on on-chip whispering gallery mode optical microcavity.

### BACKGROUND

NP complete problems, also known as Non-deterministic Polynomial problems, are one of the Millennium Prize Problems. The so-called NP problems refer to a class of computational problems that can be solved in polynomial time with a certain number of operations.

Based on this, currently in the field of computer science, the NP-complete problem is constrained by computational power and precise results cannot be obtained within effective time. However, algorithms designed using coherent Ising machines can solve problems such as maximum cutting.

However, the existing coherent Ising machines have a low integration level.

Mcmahon Peter L. et al ("A fully programmable 100-spin coherent lsing machine with all-to-all connections", vol. 354, no. 6312, 4 November 2016, pages 614-617) discloses a coherent Ising machine using a fiber-loop cavity and degenerate optical parametric oscillators (DOPOs) to simulate spin systems for solving combinatorial optimization problems. Mcmahon Peter L. et al ("A fully programmable 100-spin coherent lsing machine with all-to-all connections", vol. 354, no. 6312, 4 November 2016, pages 614-617) discloses a 100-spin coherent Ising machine that uses a 1560 nm mode-locked fiber laser as the light source. The laser pulse is frequency-doubled using a second-harmonic-generation (SHG) stage to produce a 780 nm pulse, which is injected into a fiber-ring cavity (approximately 330 meters long) containing a periodically poled lithium niobate (PPLN) waveguide. Inside the cavity, the system operates in a degenerate optical parametric oscillation (DOPO) regime, generating multiple synchronized pulses that interact to simulate spin systems for solving combinatorial optimization problems. The machine further includes a feedback loop that adjusts the phase and amplitude of the pulses based on homodyne measurements, enhancing pulse interaction within the cavity. CN105896235B discloses an optoelectronic oscillator based on multilayer whispering gallery mode optical microcavity, wherein a closed optoelectronic feedback loop consists of a laser, a polarization controller, a Mach-Zehnder intensity modulator, an RF amplifier, a filter, an optoelectronic detector, a multilayer whispering gallery mode optical microcavity and a laser frequency-locking module; and the closed optoelectronic feedback loop is the main structure of the optoelectronic oscillator.

### SUMMARY

In view of this, to resolve the foregoing problem, the present invention provides a coherent Ising machine based on on-chip whispering gallery mode optical microcavity, and in accordance with appended claim 1.

Preferably, in said coherent Ising machine, the feedback apparatus comprises an intensity modulator, a phase modulator, and an FPGA apparatus; where,
the FPGA apparatus is configured to control working statuses of the intensity modulator and the phase modulator according to an output result of the zero-beat frequency measurement apparatus, so as to adjust the amplitude and phase of the first laser pulse;
The intensity modulator is configured to adjust the amplitude of the first laser pulse; and
The phase modulator is configured to adjust the phase of the first laser pulse.

Preferably, said coherent Ising machine further comprises:
a second coupler, where the second coupler is configured to split the first laser pulse into two laser pulses; where
one laser pulse is delivered to the first laser processing apparatus; and the other laser pulse is delivered to the feedback apparatus and the zero-beat frequency measurement apparatus respectively.

Preferably, said coherent Ising machine further comprises:
an amplifier, where the amplifier is configured to amplify the first laser pulse emitted by the laser emitter.

Preferably, said coherent Ising machine further comprises a third coupler, a photoelectric converter, and an oscilloscope; where
the third coupler is configured to split the third laser pulse output from the optical microcavity into two laser pulses; where
one laser pulse is delivered to the zero-beat frequency measurement apparatus; and
the other laser pulse is delivered to the photoelectric converter;
the photoelectric converter is configured to complete photoelectric conversion of the pulsed laser;
the oscilloscope is configured to monitor a signal after photoelectric conversion.

Preferably, in said coherent Ising machine, the optical microcavity has a resonant cavity of a rotational symmetrical structure.

The coherent Ising machine mainly adopts an optical microcavity integrated with a second laser processing apparatus (a nonlinear crystal), so as to archive an on-chip structure, which, compared with the fiber loop structure in the prior art, has the integration level optimized significantly.

### BRIEF DESCRIPTION OF THE DRAWINGS

To describe the technical solutions in the embodiments of the present invention or in the prior art more clearly, the following briefly describes the accompanying drawings required for describing the embodiments or the prior art. Apparently, the accompanying drawings in the following description show merely the embodiments of the present invention, and persons of ordinary skill in the art may derive other drawings based on the provided accompanying drawings without creative efforts.
FIG. 1 is the principle and structure schematic diagram of a coherent Ising machine based on on-chip whispering gallery mode optical microcavity according to an embodiment of the present invention (not constituting a part of the present invention);
FIG. 2 is the principle and structure schematic diagram of another coherent Ising machine based on an on-chip optical microcavity in a whispering gallery mode according to an embodiment of the present invention (not constituting a part of the present invention);
FIG. 3 is the principle and structure schematic diagram of still another coherent Ising machine based on an on-chip optical microcavity in a whispering gallery mode according to an embodiment of the present invention (not constituting a part of the present invention);
FIG. 4 is the principle and structure schematic diagram of still another coherent Ising machine based on an on-chip optical microcavity in a whispering gallery mode according to an embodiment of the present invention (not constituting a part of the present invention);
FIG. 5 is the principle and structure schematic diagram of still another coherent Ising machine based on an on-chip optical microcavity in a whispering gallery mode according to an embodiment of the present invention;
FIG. 6 is the principle and structure schematic diagram of still another coherent Ising machine based on an on-chip optical microcavity in a whispering gallery mode according to an embodiment of the present invention;
FIG. 7 is the principle and structure schematic diagram of still another coherent Ising machine based on an on-chip optical microcavity in a whispering gallery mode according to an embodiment of the present invention;
FIG. 8 is the principle and structure schematic diagram of still another coherent Ising machine based on an on-chip optical microcavity in a whispering gallery mode according to an embodiment of the present invention;
FIG. 9 is the principle and structure schematic diagram of still another coherent Ising machine based on an on-chip optical microcavity in a whispering gallery mode according to an embodiment of the present invention;
FIG. 10 is the principle and structure schematic diagram of still another coherent Ising machine based on an on-chip optical microcavity in a whispering gallery mode according to an embodiment of the present invention;
FIG. 11 is the principle and structure schematic diagram of still another coherent Ising machine based on an on-chip optical microcavity in a whispering gallery mode according to an embodiment of the present invention;
FIG. 12 is the principle and structure schematic diagram of still another coherent Ising machine based on an on-chip optical microcavity in a whispering gallery mode according to an embodiment of the present invention.

### DETAILED DESCRIPTION OF THE EMBODIMENTS

The following clearly and completely describes the technical solutions in the embodiments of the present invention with reference to the accompanying drawings in the embodiments of the present invention. Apparently, the described embodiments are only some rather than all of the embodiments of the present invention. All other embodiments obtained by persons of ordinary skill in the art based on the embodiments of present invention without creative efforts shall fall within the protection scope of present invention.

In the inventive process of the present invention, the inventor has discovered that the existing coherent Ising machine uses a fiber loop structure to inject optical pulses into fiber loops for cyclic resonance. During computation, measurement feedback is obtained by outputting pulses, so as to control injection, thus constructing the coherent Ising machine and completing the computation.

In other words, the existing coherent Ising machine utilizes degenerate optical parametric oscillation in nonlinear optics to generate pulses in an optical frequency, injects the pulses into the fiber loops, and then uses a feedback injection mechanism to achieve interactions between the optical pulses, thereby accomplishing computations for problems such as maximum cutting.

However, the inventor has found that this coherent Ising machine has a low system integration level, where, several kilometers of fiber loops need to be integrated and independent nonlinear crystals are used for pumping.

Based on this, the present invention provides a coherent Ising machine based on on-chip whispering gallery mode optical microcavity, greatly improving the integration level of the coherent Ising machine and showing beneficial market effect.

In order to make the foregoing purposes, features, and advantages of the present invention more clearly and easily understood, the present invention is further described below in detail with reference to the accompanying drawings and specific embodiments.

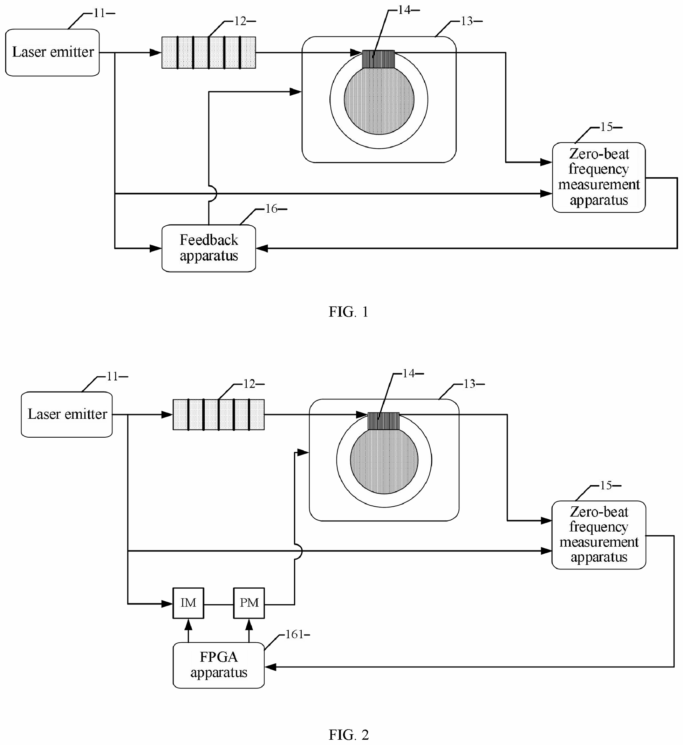

Referring to FIG. 1, FIG. 1 is the principle and structure schematic diagram of a coherent Ising machine based on on-chip whispering gallery mode optical microcavity.

The coherent Ising machine comprises:
a laser emitter 11, where the laser emitter 11 is configured to emit a first laser pulse with a first wavelength;
a first laser processing apparatus 12, where the first laser processing apparatus 12 is configured to convert the first laser pulse to a second laser pulse with a second wavelength;
an optical microcavity 13, where a second laser processing apparatus 14 is integrated in the optical microcavity 13, and the second laser processing apparatus 14 is configured to convert the second laser pulse injected into the optical microcavity 13 to a third laser pulse with the first wavelength;
a zero-beat frequency measurement apparatus 15, where the zero-beat frequency measurement apparatus 15 is configured to obtain a phase of the third laser pulse according to the first laser pulse and the third laser pulse; and
a feedback apparatus 16, where the feedback apparatus 16 is configured to adjust an amplitude and phase of the first laser pulse according to the phase of the third laser pulse, and complete injection into the optical microcavity 13 at a preset time point, to enhance the third laser pulse.

The optical microcavity 13 is an optical microcavity, in a whispering gallery mode, having a resonant cavity of a rotational symmetrical structure. The optical field can undergo total reflection on the inner surface of the optical microcavity, thus creating a standing wave effect with enhanced resonance.

Optionally, the first laser processing apparatus 12 is a periodically poled lithium niobate (PPLN) crystal, which is a grating structure.

Optionally, the second laser processing apparatus 14 is a periodically poled lithium niobate (PPLN) crystal, which is a grating structure.

The laser emitter 11 is configured to emit a first laser pulse with a first wavelength. For example, the laser emitter 11 is configured to emit the first laser pulse of 1560 nanometers.

The PPLN crystal is pumped with the first laser pulse, and during use of secondary harmonic, a laser pulse with a wavelength of 780 nanometers is generated, that is, a second laser pulse with a second wavelength.

The second laser pulse, coupled and injected into the optical microcavity 13, can induce an optical parametric oscillation process at the PPLN crystal (that is, the second laser processing apparatus 14) at a coupling end of the optical microcavity 13. As a result, a parametric oscillation pulse with a wavelength of 1560 nanometers, that is, a third laser pulse with the first wavelength, is generated.

Where, both 0 or π are taken as the phase of the degeneracy pulse signals.

In this case, the optical pulses circulate in the optical microcavity 13, forming a stable pulse sequence. When a coherent Ising network needs to be constructed, couple the pulses to the detector end of the optical microcavity 13, use the zero-beat frequency measurement apparatus 15 to perform balance zero-frequency measurement, and read the phase information of each pulse. That is, the zero-beat frequency measurement apparatus 15 is used to obtain the phase of the third laser pulse based on the first laser pulse and the third laser pulse.

Besides, feed back the read phase information to a feedback apparatus 16, and the feedback apparatus 16 adjusts the amplitude and phase of the first laser pulse split out based on the phase of the third laser pulse, and injects the first laser pulse into the optical microcavity 13 at a preset time point, so that it can interact with the original third laser pulse to enhance the third laser pulse, thus constructing an optical pulse network with interaction.

It should be noted that the optical pulse network refers to a pulse network of which each of optical pulses generated within a certain time interval serves as a node of the network, and each pulse interacts with others via a feedback injection mechanism thus forming the pulse network. It is a programmable optical pulse network with adjustable pulse timing and controllable network nodes.

Optionally, referring to FIG. 2, FIG. 2 is the principle and structure schematic diagram of another coherent Ising machine based on an on-chip optical microcavity in a whispering gallery mode.

The feedback apparatus 16 comprises an intensity modulator (IM), a phase modulator (PM), and a field programmable gate array (FPGA) apparatus 161.

The FPGA apparatus 161 is configured to control operation statuses of the intensity modulator (IM) and the phase modulator (PM) according to an output result of the zero-beat frequency measurement apparatus 15, so as to adjust the amplitude and phase of the first laser pulse.

The intensity modulator (IM) is configured to adjust the amplitude of the first laser pulse.

The phase modulator (PM) is configured to adjust the phase of the first laser pulse.

A signal receiving end of the FPGA apparatus 161 is configured to receive an output result signal of the zero-beat frequency measurement apparatus 15, that is, the phase information about each pulse read by the zero-beat frequency measurement apparatus 15. A control end of the FPGA apparatus 161 controls both the operation statuses of the intensity modulator (IM) and the phase modulator (PM), modulates the amplitude and phase of each pulse of the first laser pulse split out, and controls and makes sure the modulated pulse is injected into the optical microcavity 13 at a preset time point, so that it can interact with the original third laser pulse to enhance the third laser pulse, thus constructing an optical pulse network with interaction.

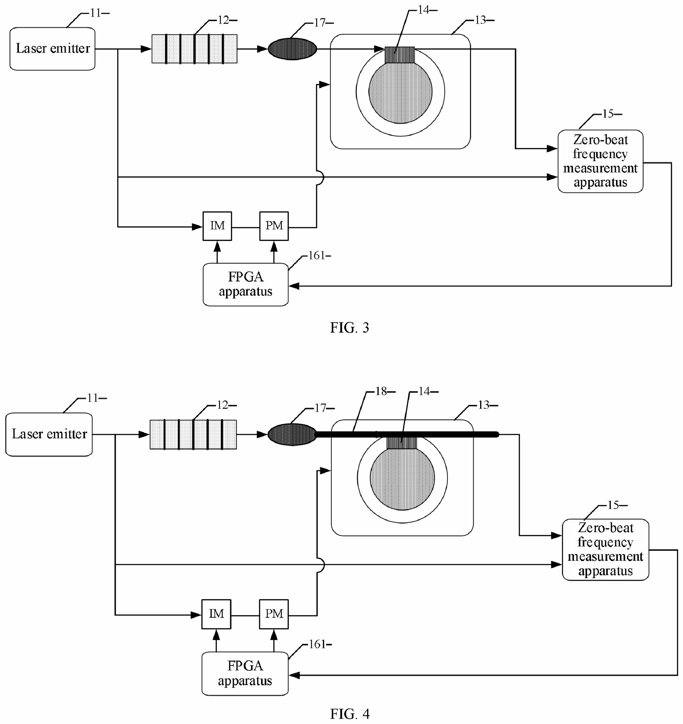

Optionally, referring to FIG. 3, FIG. 3 is the principle and structure schematic diagram of still another coherent Ising machine based on an on-chip optical microcavity in a whispering gallery mode.

The coherent Ising machine further comprises:
a first coupler 17, where the first coupler 17 is configured to inject the second laser pulse into the optical microcavity 13.

The laser emitter 11 is configured to emit a first laser pulse with a first wavelength. For example, the laser emitter 11 is configured to emit the first laser pulse of 1560 nanometers.

The PPLN crystal is pumped with the first laser pulse, and during use of secondary harmonic, a laser pulse with a wavelength of 780 nanometers is generated, that is, a second laser pulse with a second wavelength.

The first coupler 17 couples and injects the second laser pulse into the optical microcavity 13, which can enhance the pulse signal strength of the second laser pulse injected into the optical microcavity 13.

Optionally, referring to FIG. 4, FIG. 4 is the principle and structure schematic diagram of still another coherent Ising machine based on an on-chip optical microcavity in a whispering gallery mode.

An upper waveguide 18 is integrated in the optical microcavity 13; where
the first coupler 17 is configured to inject the second laser pulse into the optical microcavity 13 via the upper waveguide 18.

The laser emitter 11 is configured to emit a first laser pulse with a first wavelength. For example, the laser emitter 11 is configured to emit the first laser pulse of 1560 nanometers.

The PPLN crystal is pumped with the first laser pulse, and during use of secondary harmonic, a laser pulse with a wavelength of 780 nanometers is generated, that is, a second laser pulse with a second wavelength.

The first coupler 17 and the upper waveguide 18 couple and inject the second laser pulse into the optical microcavity 13, which can enhance the pulse signal strength of the second laser pulse injected into the optical microcavity 13.

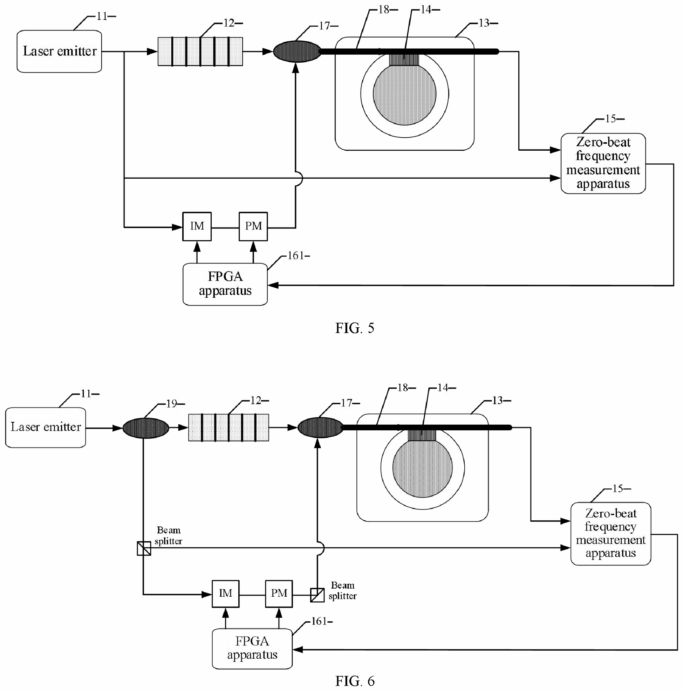

Optionally, in an embodiment of the present invention, referring to FIG. 5, FIG. 5 is the principle and structure schematic diagram of still another coherent Ising machine based on an on-chip optical microcavity in a whispering gallery mode according to an embodiment of the present invention.

The first coupler 17 is also used to inject a first pulse signal processed by the feedback apparatus 16 into the optical microcavity 13 via the upper waveguide 18.

In this embodiment, an implementation mode for injecting the modulated first laser pulse into the optical microcavity 13 is provided.

Based on the implementation mode, referring to FIG. 6, FIG. 6 is the principle and structure schematic diagram of still another coherent Ising machine based on an on-chip optical microcavity in a whispering gallery mode according to an embodiment of the present invention.

The coherent Ising machine further comprises:
a second coupler 19, where the second coupler 19 is configured to split the first laser pulse into two laser pulses; where
one laser pulse is delivered to the first laser processing apparatus 12; and the other laser pulse is delivered to the feedback apparatus16 and the zero-beat frequency measurement apparatus 15 respectively.

In this embodiment, the second coupler 19 is configured to split the laser pulse. One laser pulse is used for pumping the PPLN crystal, and during use of secondary harmonic, a laser pulse with a wavelength of 780 nanometers is generated, that is, a second laser pulse with a second wavelength.

The other laser pulse is, without limitation, delivered through the beam splitter to the feedback apparatus 16 and the zero-beat frequency measurement apparatus 15 respectively.

It should be noted that the laser pulse possessed by the feedback apparatus 16, will be, without limitation, fed back to the first coupler 17 through the splitter.

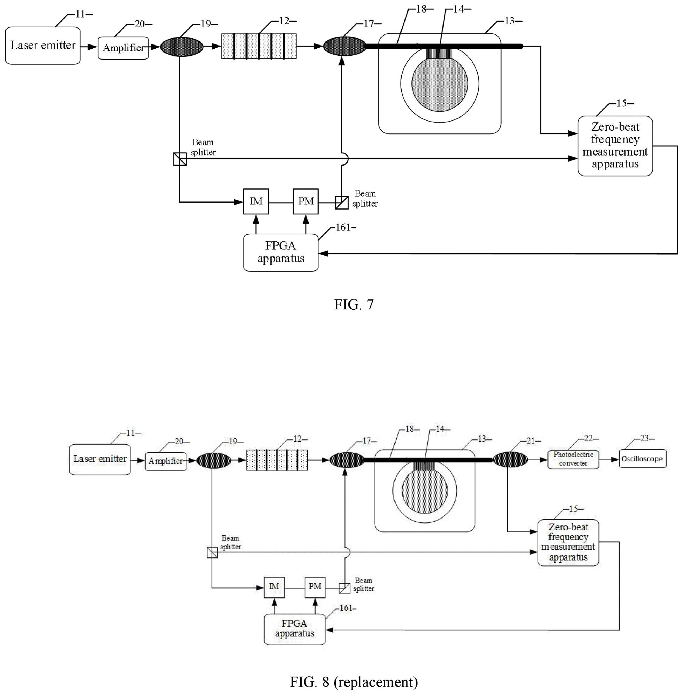

Based on the implementation mode, referring to FIG. 7, FIG. 7 is the principle and structure schematic diagram of still another coherent Ising machine based on an on-chip optical microcavity in a whispering gallery mode according to an embodiment of the present invention.

The coherent Ising machine further comprises:
an amplifier 20, where the amplifier 20 is configured to amplify the first laser pulse emitted by the laser emitter 11.

In this embodiment, the amplifier 20 is arranged between the second coupler 19 and the laser emitter 11, and is configured to amplify the first laser pulse emitted by the laser emitter 11.

The amplifier 20 includes but is not limited to an erbium-doped optical fiber amplifier (EDFA), which is an active optical device for signal amplification.

Based on the implementation mode, referring to FIG. 8, FIG. 8 is the principle and structure schematic diagram of still another coherent Ising machine based on an on-chip optical microcavity in a whispering gallery mode according to an embodiment of the present invention.

The coherent Ising machine further comprises a third coupler 21, a photoelectric converter 22, and an oscilloscope 23; where
the third coupler 21 is configured to split the third laser pulse output from the optical microcavity 13 into two laser pulses;
one laser pulse is delivered to the zero-beat frequency measurement apparatus 15; and
the other laser pulse is delivered to the photoelectric converter 22;
the photoelectric converter 22 is configured to complete photoelectric conversion of the pulsed laser;
the oscilloscope 23 is configured to monitor a signal after photoelectric conversion.

In this embodiment, the optical pulses injected into the optical microcavity 13 circulate in the optical microcavity 13 and form a stable pulse sequence. When a coherent Ising network needs to be constructed, the upper waveguide 18 and the third coupler 21 couple the pulses to the detector end of the optical microcavity 13 for splitting.

One laser pulse is delivered to the zero-beat frequency measurement apparatus 15, then use the zero-beat frequency measurement apparatus 15 to perform balance zero-frequency measurement, and read the phase information of each pulse. That is, the zero-beat frequency measurement apparatus 15 is configured to obtain the phase of the third laser pulse according to the first laser pulse and the third laser pulse.

The other laser pulse is processed by the photoelectric converter 22, and signals are monitored by the oscilloscope 23.

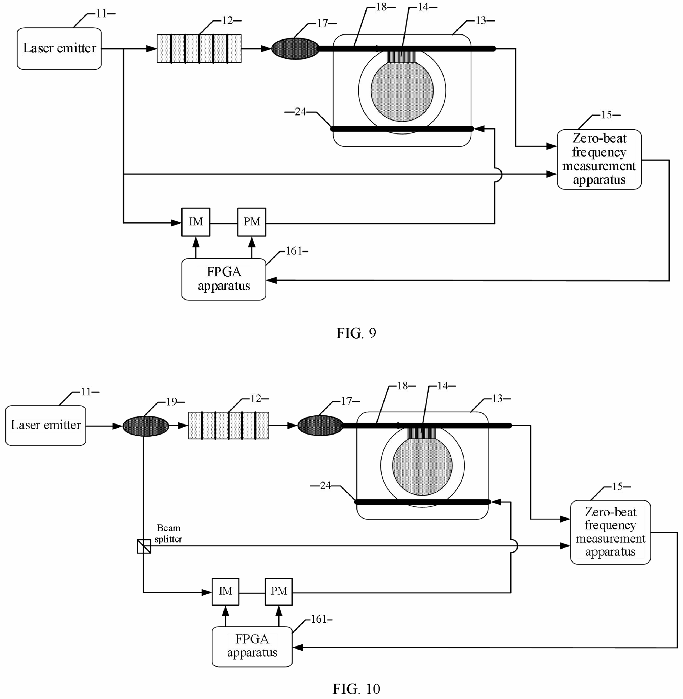

Optionally, in another embodiment of the present invention, based on the coherent Ising machine in FIG. 4, referring to FIG. 9, FIG. 9 is the principle and structure schematic diagram of still another coherent Ising machine based on an on-chip optical microcavity in a whispering gallery mode according to an embodiment of the present invention.

A lower waveguide 24 is integrated in the optical microcavity 13; where
the first pulse signal processed by the feedback apparatus 16 is injected into the optical microcavity 13 via the lower waveguide 24.

In this embodiment, another implementation mode for injecting the modulated first laser pulse into the optical microcavity 13 is provided.

Based on the implementation mode, referring to FIG. 10, FIG. 10 is the principle and structure schematic diagram of still another coherent Ising machine based on an on-chip optical microcavity in a whispering gallery mode according to an embodiment of the present invention.

The coherent Ising machine further comprises:
a second coupler 19, where the second coupler 19 is configured to split the first laser pulse into two laser pulses; where
one laser pulse is delivered to the first laser processing apparatus 12; and the other laser pulse is delivered to the feedback apparatus16 and the zero-beat frequency measurement apparatus 15 respectively.

In this embodiment, the second coupler 19 is configured to split the laser pulse. One laser pulse is used for pumping the PPLN crystal, and during use of secondary harmonic, a laser pulse with a wavelength of 780 nanometers is generated, that is, a second laser pulse with a second wavelength.

The other laser pulse is, including without limitation, delivered through the beam splitter to the feedback apparatus 16 and the zero-beat frequency measurement apparatus 15 respectively.

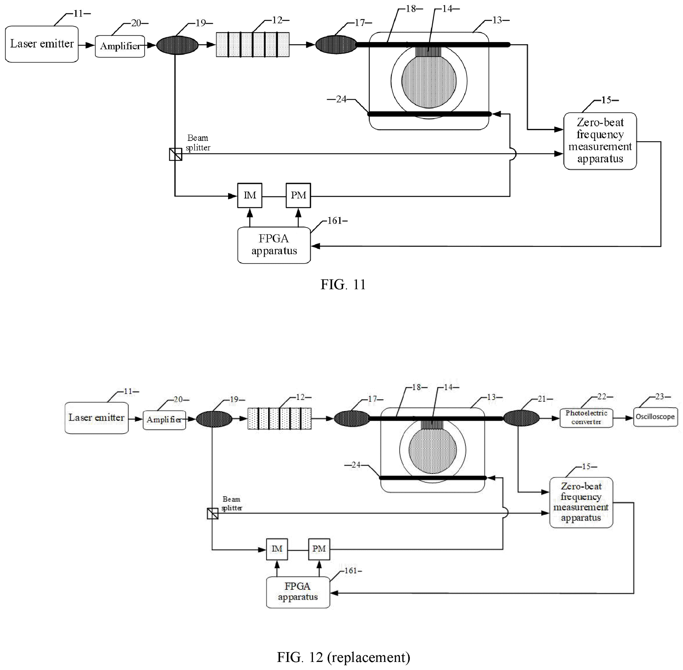

Based on the implementation mode, referring to FIG. 11, FIG. 11 is the principle and structure schematic diagram of still another coherent Ising machine based on an on-chip optical microcavity in a whispering gallery mode according to an embodiment of the present invention.

The coherent Ising machine further comprises:
an amplifier 20, where the amplifier 20 is configured to amplify the first laser pulse emitted by the laser emitter 11.

In this embodiment, the amplifier 20 is arranged between the second coupler 19 and the laser emitter 11, and is configured to amplify the first laser pulse emitted by the laser emitter 11.

The amplifier 20 includes but is not limited to an erbium-doped optical fiber amplifier (EDFA), which is an active optical device for signal amplification.

Based on the implementation mode, referring to FIG. 12, FIG. 12 is the principle and structure schematic diagram of still another coherent Ising machine based on an on-chip optical microcavity in a whispering gallery mode according to an embodiment of the present invention.

The coherent Ising machine further comprises a third coupler 21, a photoelectric converter 22, and an oscilloscope 23; where
the third coupler 21 is configured to split the third laser pulse output from the optical microcavity 13 into two laser pulses;
one laser pulse is delivered to the zero-beat frequency measurement apparatus 15; and
the other laser pulse is delivered to the photoelectric converter 22;
the photoelectric converter 22 is configured to complete photoelectric conversion of the pulsed laser;
the oscilloscope 23 is configured to monitor a signal after photoelectric conversion.

In this embodiment, the optical pulses injected into the optical microcavity 13 circulate in the optical microcavity 13 and form a stable pulse sequence. When a coherent Ising network needs to be constructed, the upper waveguide 18 and the third coupler 21 couple the pulses to the detector end of the optical microcavity 13 for splitting.

One laser pulse is delivered to the zero-beat frequency measurement apparatus 15, then use the zero-beat frequency measurement apparatus 15 to perform balance zero-frequency measurement, and read the phase information of each pulse. That is, the zero-beat frequency measurement apparatus 15 is configured to obtain the phase of the third laser pulse according to the first laser pulse and the third laser pulse.

The other laser pulse is processed by the photoelectric converter 22, and signals are monitored by the oscilloscope 23.

It can be known from the foregoing description that for the coherent Ising machine based on an on-chip optical microcavity in a whispering gallery mode provided in the embodiments of the present invention, two nonlinear optical processes can be completed by using the PPLN crystal integrated in the optical microcavity, even when the degeneracy optical parametric oscillation process and the circulating of optical pulses occur simultaneously in the integrated optical microcavity.

In addition, the optical microcavity in the whispering gallery mode is used, which, compared with the fiber loop structure in the prior art, has greatly improved the integration level. Furthermore, non-linear crystals are integrated, so that the whole system is of a chip structure, resolving the problem of chip integration in the CIM system.

The coherent Ising machine based on an on-chip optical microcavity in a whispering gallery mode provided by the present invention is described in detail above. The principle and the implementations of the present invention are described herein using specific examples. The descriptions about the embodiments are merely provided to help understand the method and the core idea of the present invention. In addition, a person of ordinary skill in the art can make changes to the specific implementations and the application scope in accordance with the scope of the claimed invention.

In conclusion, the content of this Description shall not be construed as a limitation to the present invention.

It should be noted that for the purpose of this Description, all embodiments are described in a progressive manner, and the description of each embodiment focuses on differences from one another. For the same or similar content among embodiments, cross-reference can be made.

It should be noted that relational terms such as "first" and "second" are only used to distinguish one entity or operation from another entity or operation, and do not necessarily require or imply that there is any such actual relationship or order between these entities or operations. Terms "comprise(s)", "include(s)", or any other variations thereof are intended to cover non-exclusive inclusions, such that a process, method, article or device comprising a series of elements not only comprises said elements, but also comprises other elements which are not expressly listed, or further comprises elements which are inherent to such process, method, article or device. In the absence of more restrictions, the elements defined by the sentence "comprise(s)..." do not rule out additional identical elements that may be contained in the process, method, article or device comprising said elements.

## Claims

1. A coherent Ising machine based on an on-chip whispering gallery mode optical microcavity, wherein the coherent Ising machine comprises:
a laser emitter (11), wherein the laser emitter (11) is used to emit a first laser pulse with a first wavelength;
a first laser processing apparatus (12), wherein the first laser processing apparatus (12) is configured to convert the first laser pulse to a second laser pulse with a second wavelength;
an optical microcavity (13), wherein a second laser processing apparatus (14) is integrated in the optical microcavity (13), and the second laser processing apparatus (14) is configured to convert the second laser pulse injected into the optical microcavity (13) to a third laser pulse with the first wavelength, and the second laser processing apparatus is a periodically poled lithium niobate, PPLN, crystal and integrated at a coupling end of the optical microcavity;
a zero-beat frequency measurement apparatus (15), wherein the zero-beat frequency measurement apparatus (15) is configured to obtain a phase of the third laser pulse according to the first laser pulse and the third laser pulse;
a feedback apparatus (16), wherein an input of the feedback apparatus (16) is connected between the laser emitter (11) and the first laser processing apparatus (12), the feedback apparatus (16) is configured to adjust an amplitude and phase of the first laser pulse according to the phase of the third laser pulse, and complete injection into the optical microcavity (13) at a preset time point, to enhance the third laser pulse, wherein the preset time point is set so the first laser pulse can interact with the third laser pulse; and
a first coupler (17), wherein the first coupler (17) is connected between the first laser processing apparatus (12) and the optical microcavity (13), and configured to inject the second laser pulse into the optical microcavity (13) via an upper waveguide (18) configured in the optical microcavity (13);
wherein the first coupler (17), connected also between the feedback apparatus (16) and the optical microcavity (13), is configured to inject a first pulse signal processed by the feedback apparatus (16) into the optical microcavity (13) via the upper waveguide (18), or wherein a lower waveguide (24), configured in the optical microcavity (13), is configured to inject a first pulse signal processed by the feedback apparatus (16) into the microcavity (13).

2. The coherent Ising machine according to claim 1, wherein
the feedback apparatus (16) comprises an intensity modulator (IM), a phase modulator (PM), and a field programmable gate array (FPGA) apparatus; wherein
the FPGA apparatus is configured to control working statuses of the intensity modulator (IM) and the phase modulator (PM) according to an output result of the zero-beat frequency measurement apparatus (15), so as to adjust the amplitude and phase of the first laser pulse;
the intensity modulator (IM) is configured to adjust the amplitude of the first laser pulse; and
the phase modulator (PM) is configured to adjust the phase of the first laser pulse.

3. The coherent Ising machine according to claim 1, further comprising
a second coupler (19), wherein the second coupler (19) is configured to split the first laser pulse into two laser pulses; wherein
one laser pulse is delivered to the first laser processing apparatus (12); and the other laser pulse is delivered to the feedback apparatus (16) and the zero-beat frequency measurement apparatus (15) respectively.

4. The coherent Ising machine according to claim 1, further comprising
an amplifier (20), wherein the amplifier (20) is configured to amplify the first laser pulse emitted by the laser emitter (11).

5. The coherent Ising machine according to claim 1, further comprising a third coupler (21), a photoelectric converter (22), and an oscilloscope (23);
the third coupler (21) is configured to split the third laser pulse output from the optical microcavity (13) into two laser pulses; wherein
one laser pulse is delivered to the zero-beat frequency measurement apparatus (15); and
the other laser pulse is delivered to the photoelectric converter (22); the photoelectric converter (22) is configured to complete photoelectric conversion of the pulsed laser; and the oscilloscope (23) is configured to monitor a signal after photoelectric conversion.

6. The coherent Ising machine according to claim 1, wherein the optical microcavity (13) has a resonant cavity of a rotational symmetrical structure.

## Patentansprüche

1. Eine kohärente Ising-Maschine auf Basis einer optischen On-Chip-Mikrokavität mit Flüstergaleriemode, wobei die kohärente Ising-Maschine umfasst:
einen Laseremitter (11), wobei der Laseremitter (11) verwendet wird, um einen ersten Laserpuls mit einer ersten Wellenlänge zu emittieren;
eine erste Laserbearbeitungsvorrichtung (12), wobei die erste Laserbearbeitungsvorrichtung (12) dazu konfiguriert ist, den ersten Laserpuls in einen zweiten Laserpuls mit einer zweiten Wellenlänge umzuwandeln;
eine optische Mikrokavität (13), wobei eine zweite Laserbearbeitungsvorrichtung (14) in die optische Mikrokavität (13) integriert ist, und die zweite Laserbearbeitungsvorrichtung (14) dazu konfiguriert ist, den in die optische Mikrokavität (13) injizierten zweiten Laserpuls in einen dritten Laserpuls mit der ersten Wellenlänge umzuwandeln, und die zweite Laserbearbeitungsvorrichtung ein periodisch gepolter Lithiumniobat-, PPLN-, Kristall ist und an einem Kopplungsende der optischen Mikrokavität integriert ist;
eine Nullschwebungsfrequenz-Messvorrichtung (15), wobei die Nullschwebungsfrequenz-Messvorrichtung (15) dazu konfiguriert ist, gemäß dem ersten Laserpuls und dem dritten Laserpuls eine Phase des dritten Laserpulses zu erhalten;
eine Rückkopplungsvorrichtung (16), wobei ein Eingang der Rückkopplungsvorrichtung (16) zwischen dem Laseremitter (11) und der ersten Laserbearbeitungsvorrichtung (12) angeschlossen ist, die Rückkopplungsvorrichtung (16) dazu konfiguriert ist, eine Amplitude und Phase des ersten Laserpulses gemäß der Phase des dritten Laserpulses einzustellen und eine Injektion in die optische Mikrokavität (13) zu einem voreingestellten Zeitpunkt abzuschließen, um den dritten Laserpuls zu verstärken, wobei der voreingestellte Zeitpunkt so eingestellt ist, dass der erste Laserpuls mit dem dritten Laserpuls wechselwirken kann; und
einen ersten Koppler (17), wobei der erste Koppler (17) zwischen der ersten Laserbearbeitungsvorrichtung (12) und der optischen Mikrokavität (13) angeschlossen und dazu konfiguriert ist, den zweiten Laserpuls über einen in der optischen Mikrokavität (13) konfigurierten oberen Wellenleiter (18) in die optische Mikrokavität (13) zu injizieren;
wobei der erste Koppler (17), der auch zwischen der Rückkopplungsvorrichtung (16) und der optischen Mikrokavität (13) angeschlossen ist, dazu konfiguriert ist, ein durch die Rückkopplungsvorrichtung (16) bearbeitetes erstes Pulssignal über den oberen Wellenleiter (18) in die optische Mikrokavität (13) zu injizieren, oder wobei ein in der optischen Mikrokavität (13) konfigurierter unterer Wellenleiter (24) dazu konfiguriert ist, ein durch die Rückkopplungsvorrichtung (16) bearbeitetes erstes Pulssignal in die Mikrokavität (13) zu injizieren.

2. Kohärente Ising-Maschine nach Anspruch 1, wobei die Rückkopplungsvorrichtung (16) einen Intensitätsmodulator (IM), einen Phasenmodulator (PM) und eine Field-Programmable-Gate-Array-(FPGA)-Vorrichtung umfasst; wobei
die FPGA-Vorrichtung dazu konfiguriert ist, Arbeitszustände des Intensitätsmodulators (IM) und des Phasenmodulators (PM) gemäß einem Ausgangsergebnis der Nullschwebungsfrequenz-Messvorrichtung (15) zu steuern, um die Amplitude und Phase des ersten Laserpulses einzustellen;
der Intensitätsmodulator (IM) dazu konfiguriert ist, die Amplitude des ersten Laserpulses einzustellen; und
der Phasenmodulator (PM) dazu konfiguriert ist, die Phase des ersten Laserpulses einzustellen.

3. Kohärente Ising-Maschine nach Anspruch 1, ferner umfassend
einen zweiten Koppler (19), wobei der zweite Koppler (19) dazu konfiguriert ist, den ersten Laserpuls in zwei Laserpulse aufzuteilen; wobei
ein Laserpuls zu der ersten Laserbearbeitungsvorrichtung (12) geleitet wird; und der andere Laserpuls jeweils zu der Rückkopplungsvorrichtung (16) und der Nullschwebungsfrequenz-Messvorrichtung (15) geleitet wird.

4. Kohärente Ising-Maschine nach Anspruch 1, ferner umfassend
einen Verstärker (20), wobei der Verstärker (20) dazu konfiguriert ist, den von dem Laseremitter (11) emittierten ersten Laserpuls zu verstärken.

5. Kohärente Ising-Maschine nach Anspruch 1, ferner umfassend
einen dritten Koppler (21), einen photoelektrischen Wandler (22) und ein Oszilloskop (23);
der dritte Koppler (21) ist dazu konfiguriert, den aus der optischen Mikrokavität (13) ausgegebenen dritten Laserpuls in zwei Laserpulse aufzuteilen; wobei
ein Laserpuls zu der Nullschwebungsfrequenz-Messvorrichtung (15) geleitet wird; und
der andere Laserpuls zu dem photoelektrischen Wandler (22) geleitet wird; der photoelektrische Wandler (22) dazu konfiguriert ist, eine photoelektrische Umwandlung des gepulsten Lasers abzuschließen; und das Oszilloskop (23) dazu konfiguriert ist, ein Signal nach der photoelektrischen Umwandlung zu überwachen.

6. Kohärente Ising-Maschine nach Anspruch 1, wobei die optische Mikrokavität (13) einen Resonanzhohlraum mit einer rotationssymmetrischen Struktur aufweist.

## Revendications

1. Machine d'Ising cohérente basée sur une microcavité optique sur puce en mode galerie chuchotante, dans laquelle la machine d'Ising cohérente comprend :
un émetteur laser (11), dans lequel l'émetteur laser (11) est utilisé pour émettre une première impulsion laser avec une première longueur d'onde ;
un premier appareil de traitement laser (12), dans laquelle le premier appareil de traitement laser (12) est configuré pour convertir la première impulsion laser en une deuxième impulsion laser avec une deuxième longueur d'onde ;
une microcavité optique (13), dans laquelle un deuxième appareil de traitement laser (14) est intégré dans la microcavité optique (13), et le deuxième appareil de traitement laser (14) est configuré pour convertir la deuxième impulsion laser injectée dans la microcavité optique (13) en une troisième impulsion laser avec la première longueur d'onde, et le deuxième appareil de traitement laser est un cristal de niobate de lithium à polarisation périodique, PPLN, et intégré au niveau d'une extrémité de couplage de la microcavité optique ;
un appareil de mesure de fréquence à battement nul (15), dans laquelle l'appareil de mesure de fréquence à battement nul (15) est configuré pour obtenir une phase de la troisième impulsion laser en fonction de la première impulsion laser et de la troisième impulsion laser ;
un appareil à rétroaction (16), dans laquelle une entrée de l'appareil à rétroaction (16) est connectée entre l'émetteur laser (11) et le premier appareil de traitement laser (12), l'appareil à rétroaction (16) est configuré pour ajuster une amplitude et une phase de la première impulsion laser en fonction de la phase de la troisième impulsion laser, et achever l'injection dans la microcavité optique (13) à un instant prédéfini, pour renforcer la troisième impulsion laser, dans laquelle l'instant prédéfini est défini de sorte que la première impulsion laser puisse interagir avec la troisième impulsion laser ; et
un premier coupleur (17), dans laquelle le premier coupleur (17) est connecté entre le premier appareil de traitement laser (12) et la microcavité optique (13), et configuré pour injecter la deuxième impulsion laser dans la microcavité optique (13) via un guide d'onde supérieur (18) configuré dans la microcavité optique (13) ;
dans laquelle le premier coupleur (17), connecté également entre l'appareil à rétroaction (16) et la microcavité optique (13), est configuré pour injecter un premier signal à impulsions traité par l'appareil à rétroaction (16) dans la microcavité optique (13) via le guide d'onde supérieur (18), ou dans laquelle un guide d'onde inférieur (24), configuré dans la microcavité optique (13), est configuré pour injecter un premier signal à impulsions traité par l'appareil à rétroaction (16) dans la microcavité (13).

2. Machine d'Ising cohérente selon la revendication 1, dans laquelle l'appareil à rétroaction (16) comprend un modulateur d'intensité (IM), un modulateur de phase (PM) et un appareil à réseau de portes programmables in situ (FPGA) ; dans laquelle
l'appareil à FPGA est configuré pour commander des états de fonctionnement du modulateur d'intensité (IM) et du modulateur de phase (PM) en fonction d'un résultat de sortie de l'appareil de mesure de fréquence à battement nul (15), de façon à ajuster l'amplitude et la phase de la première impulsion laser ;
le modulateur d'intensité (IM) est configuré pour ajuster l'amplitude de la première impulsion laser ; et
le modulateur de phase (PM) est configuré pour ajuster la phase de la première impulsion laser.

3. Machine d'Ising cohérente selon la revendication 1, comprenant en outre
un deuxième coupleur (19), dans laquelle le deuxième coupleur (19) est configuré pour diviser la première impulsion laser en deux impulsions laser ; dans laquelle
une impulsion laser est délivrée au premier appareil de traitement laser (12) ; et l'autre impulsion laser est délivrée à l'appareil à rétroaction (16) et à l'appareil de mesure de fréquence à battement nul (15), respectivement.

4. Machine d'Ising cohérente selon la revendication 1, comprenant en outre
un amplificateur (20), dans laquelle l'amplificateur (20) est configuré pour amplifier la première impulsion laser émise par l'émetteur laser (11).

5. Machine d'Ising cohérente selon la revendication 1, comprenant en outre
un troisième coupleur (21), un convertisseur photoélectrique (22) et un oscilloscope (23) ;
le troisième coupleur (21) est configuré pour diviser la troisième impulsion laser sortant de la microcavité optique (13) en deux impulsions laser ; dans laquelle
une impulsion laser est délivrée à l'appareil de mesure de fréquence à battement nul (15) ; et
l'autre impulsion laser est délivrée au convertisseur photoélectrique (22) ; le convertisseur photoélectrique (22) est configuré pour achever la conversion photoélectrique du laser pulsé ; et l'oscilloscope (23) est configuré pour surveiller un signal après conversion photoélectrique.

6. Machine d'Ising cohérente selon la revendication 1, dans laquelle la microcavité optique (13) présente une cavité résonante d'une structure symétrique en rotation.
